# EUROPÄISCHE PATENTSCHRIFT

(11) **EP 2 960 990 B1**
(45) Veröffentlichungstag und Bekanntmachung des Hinweises auf die Patenterteilung: **08.08.2018**
(21) Anmeldenummer: 14306011.9
(22) Anmeldetag: 26.06.2014
(51) Int. Cl.: H01R 13/6591, H01B 1/02, H01B 3/30, H01R 13/6598, H05K 9/00, H02G 15/068

(54) **Anordnung zur elektromagnetischen Abschirmung**
Electromagnetic shielding structure
Agencement de blindage électromagnétique

(43) Veröffentlichungstag der Anmeldung: 30.12.2015
(73) Patentinhaber: Nexans, 92400 Courbevoie (FR)
(72) Erfinder: Steinberg, Helmut, 92721 Störnstein (DE)
(74) Vertreter: Feray, Valérie

(56) Entgegenhaltungen:
- EP-A2- 1 744 409
- WO-A1-2013/047897
- DE-A1- 3 438 660
- DE-A1- 19 518 541
- DE-A1- 19 907 675
- GB-A- 2 230 151
- US-A1- 2012 319 055
- US-B1- 6 861 138

## Beschreibung

Die Erfindung bezieht sich auf eine Anordnung zur elektromagnetischen Abschirmung gemäß dem Oberbegriff des Patentanspruchs 1.

Eine solche Anordnung geht beispielsweise aus der DE 199 07 675 A1 hervor.

Elektrische Leitungen, welche mindestens einen von einer Isolierung umgebenen elektrischen Leiter und einen die Isolierung umgebenden elektrisch wirksamen Schirm aufweisen, werden seit Jahren weltweit eingesetzt. Der elektrisch wirksame Schirm besteht überwiegend aus Kupferdrähten, welche als Geflecht oder als Umseilung um die Isolierung des Leiters herumgeformt sind.

Besonders in Kraftfahrzeugen oder in Flugzeugen kommt eine große Anzahl solcher geschirmter Leitungen zum Einsatz, die beispielsweise in Kabelbäumen oder zu Kabelsätzen zu kompakten Einheiten zusammengefaßt sein können. Das Gewicht einer solchen elektrischen, geschirmten Leitung ist deshalb ausschlaggebend.

Insbesondere in der Automobil- und Luftfahrtindustrie ist man deshalb bestrebt, das Gewicht der Leitungseinheiten zu senken, um hauptsächlich den Kraftstoffverbrauch zu reduzieren. Aus diesem Grunde ist es beispielsweise bekannt, für die elektrischen Leiter Aluminium oder Aluminiumlegierungen anstatt Kupfer einzusetzen oder Karosserien aus Kunststoff zu erzeugen.

Die geschirmten Leitungen sind in der Regel mit Kupplungselementen, wie Buchsen oder Stecker, verbunden, um an weitere elektrische Anlagen, beispielsweise an elektrische Bauteile, weiterführende Leitungen oder die Karosserie eines Kraftfahrzeugs angeschlossen werden zu können. Die Kupplungselemente können für störende elektromagnetische Felder, welche von außen auf die Leitung einwirken oder von der Leitung selbst erzeugt werden können, durchlässig sein. Die gewünschte elektromagnetische Verträglichkeit solcher Anordnungen kann dadurch beeinträchtigt werden.

Die eingangs erwähnte DE 199 07 675 A1 betrifft einen Kabelschirm aus Faserverbundwerkstoff mit hohem Anteil an elektrisch leitfähigen Fasern zur elektromagnetischen Abschirmung. Als Kabel sind ein verdrillter Doppelleiter und ein Koaxialkabel beschrieben. Der Doppelleiter ist durch ein denselben umgebendes, mit Gummilösung getränktes Kohlefasergeflecht elektromagnetisch geschirmt. Der Außenleiter des Koaxialkabels besteht aus einem Kohlefasergeflecht. Ein entsprechendes System führt zu einem geringeren Gewicht einer Verkabelung. Es ermöglicht bei Landfahrzeugen höhere Geschwindigkeiten. Der Kontakt zwischen dem Kabelschirm und einem Stecker, über den in der Druckschrift nur eine spezielle Klemmtechnik erwähnt ist, wird nicht durch Korrosionsbildung negativ beeinflußt. Weiterer Stand der Technik wird in US6861138B1, DE3438660A1, WO2013/047897A1, EP1744409A2 und DE19518541A1 offenbart. Der Erfindung liegt die Aufgabe zugrunde, eine Anordnung zur elektromagnetischen Abschirmung einer Verbindung zwischen einer elektrischen Leitung und einem Kupplungselement bereitzustellen, welche eine lückenlose Abschirmung von der Leitung bis über das Kupplungselement und die an dieses angeschlossene weitere elektrischen Anlagen gewährleistet.

Diese Aufgabe wird entsprechend den kennzeichnenden Merkmalen des Patentanspruchs 1 gelöst.

Diese Anordnung erlaubt eine wirksame elektromagnetische Abschirmung der Verbindung zwischen Leitung und Kupplungselement, welche sicherstellt, daß die elektromagnetische Verträglichkeit der Verbindung innerhalb einer elektrischen Anlage nicht durch das Vorhandensein eines Kupplungselements beeinträchtigt wird. Die Schirme der Leitung und des Kupplungselements werden auf dasselbe Potential gelegt. Die Anordnung weist außerdem mehrere Vorteile gegenüber einer konventionellen Anordnung mit metallischem Kabelschirm, metallischem Stecker- oder Buchsengehäuse und mit metallischen Kontaktelementen auf. Die Anordnung ist von besonders geringem Gewicht und deshalb mit Vorteil für die Nutzung in Kraftfahrzeugen und Luftfahrzeugen geeignet. Beispielsweise kann sie für Starkstromanwendungen in Hybrid- oder Elektrofahrzeugen eingesetzt werden. Außerdem ist die Anordnung sicher, langlebig und sehr kostengünstig.

Ein Kohlenstofffasern enthaltender Kunststoff wird umgangssprachlich als Carbon bezeichnet. Diese Bezeichnung soll auch im Folgenden verwendet werden. Carbon ist ein Faser-Kunststoff-Verbundwerkstoff, bei welchem Kohlenstofffasern in eine Kunststoff-Matrix eingebettet sind. Der Kunststoff besteht beispielweise aus einem Duroplast, zum Beispiel Epoxidharz, aus einem Thermoplast oder aus Keramik. Carbon hat eine elektrische Leitfähigkeit, welche geringer als die des Kupfers, aber für eine wirksame elektromagnetische Abschirmung, insbesondere im Automobilbereich, ausreichend ist.

Der Schirm des Kupplungselements und der Schirm der Leitung sind mittels eines elektrisch leitfähigen Klebemittels miteinander zu dem Gesamtschirm verbunden. Die Verwendung eines elektrisch leitfähigen Klebemittels ist von besonderem Vorteil, weil dieses während der Herstellung des Gesamtschirms jeweils in die Matrixstruktur des Carbons der einzelnen Schirme eindringt, womit nach dem Aushärten des Klebemittels ein besonders fester stoffschlüssiger Verbund zwischen den beiden Schirmen erreicht wird.

Die Anordnung wird in einer besonders bevorzugten Ausführungsform im Automobilbau eingesetzt, und zwar für elektrisch leitende Verbindungen innerhalb eines Kraftfahrzeugs.

Die Anordnung gemäß der Erfindung wird anhand der Zeichnung erläutert.

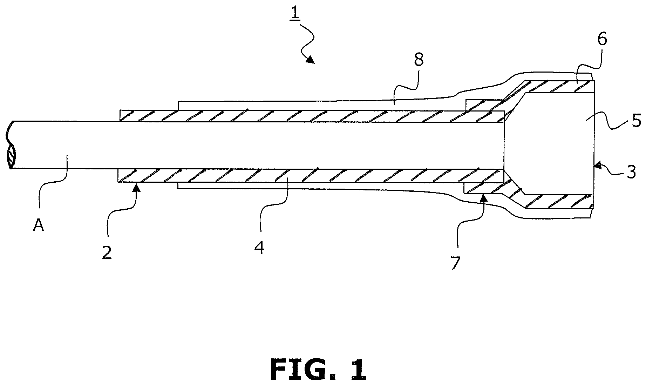

Fig. 1 zeigt schematisch ein Ausführungsbeispiel einer Anordnung zur elektromagnetischen Abschirmung einer Verbindung zwischen einer elektrischen Leitung und einem elektrischen Kupplungselement.

In Fig. 1 ist schematisch das Ende einer elektrischen Leitung 2 dargestellt. Die Leitung 2 umfaßt eine Ader A, welche einen elektrischen Leiter und eine diesen umgebende Isolierung aus Kunsttstoff (nicht dargestellt) aufweist. Der elektrische Leiter kann beispielsweise als Massivleiter oder als Litzenleiter ausgeführt sein. Er kann beispielsweise aus Kupfer oder aus Aluminium bzw. aus einer Aluminiumlegierung bestehen.

Um die Ader A herum ist ein elektrisch wirksamer Schirm 4 aus Carbon angebracht. Das Carbon liegt beispielweise in Form von Fasern oder Fäden vor, die beispielsweise mittels einer bekannten Flechtmaschine als Geflecht oder als Umseilung um die Isolierung der Ader A herumgeformt werden können. Das Carbon kann auch als vorbereitetes Band um die Ader A herumgewickelt werden. Weiterhin kann das Carbon als Schlauch vorgeformt und anschließend über die Ader A gezogen bzw. geschoben werden. Der Schlauch kann dann durch Zugbelastung bis zur Anlage auf der Isolierung der Ader A heruntergezogen werden.

Die Leitung 2 ist mit einem elektrischen Kupplungselement 3 verbunden. Das schematisch angedeutete Kupplungselement 3 ist beispielsweise ein Stecker oder eine Buchse. Auch das Gehäuse 5 des Kupplungselements 3 ist von einem elektrisch wirksamen Schirm 6 aus Carbon umgeben. Dieser Carbon-Schirm 6 kann in ähnlicher Weise wie bei der Leitung 2 auf das Kupplungselement 3 aufgebracht werden. Das Gehäuse 5 des Kupplungselements 3 besteht mit Vorteil aus isolierendem Kunststoff.

Der Schirm 6 des Kupplungselements 3 ist mit dem Schirm 4 der Leitung 2 stoffschlüssig verbunden. Die beiden Schirme 4 und 6 bilden deshalb einen Gesamtschirm, welcher die Verbindung zwischen Leitung 2 und Kupplungselement 3 lückenlos umschließt.

Die stoffschlüssige Verbindung der Schirme 4 und 6 der Leitung 2 und des Kupplungselements 3 wird durch ein elektrisch leitfähiges Klebemittel erreicht. Das Klebemittel wird auf die Carbon-Faser- bzw. -Faden-Struktur beider Schirme 4 und 6 aufgebracht, wodurch diese mit dem Klebemittel durchtränkt werden. Die beiden so durchtränkten Schirme 4 und 6 werden anschließend zur Anlage aufeinander gebracht. Beispielsweise kann der Schirm 6 des Kupplungselements 3 etwas über den Schirm 4 der Leitung 2 überstehen und auf diesem aufliegen, wie in Fig. 1 an der Bezugsnummer 7 dargestellt. Beim Aushärten des Klebemittels entsteht die stoffschlüssige Verbindung zwischen den beiden Schirmen 4 und 6. Das leitfähige Klebemittel kann beispielsweise ein Epoxidharz oder ein Polyesterharz sein, welches mit leitfähigen Partikeln, beispielsweise aus Nickel oder aus Kohlenstoff, versetzt ist. Die mit dem Gesamtschirm versehene Verbindung 1 zwischen der Leitung 2 und dem Kupplungselement 3 kann weiterhin von einer Schicht 8 aus Isoliermaterial umgeben sein. Die Schicht 8 dient als Berührungsschutz. Sie kann beispielsweise in einem Gießprozeß auf die Verbindung 1 aufgetragen werden. Handelt es sich bei der Leitung 2 um ein normalerweise nicht stromführendes Kabel, beispielsweise um ein mit dem Motorgehäuse verbundenes Erdungskabel in einem Kraftfahrzeug, so kann auf die Isolierschicht 8 verzichtet werden.

Für die Isolierung der Ader 2, das Gehäuse 5 des Kupplungsteils 3 und die abschließende Schicht 8 geeignete Materialien sind beispielsweise Polyethylen, Polypropylen, Polyvinylchlorid und Polyurethan.

## Patentansprüche

1. Anordnung zur elektromagnetischen Abschirmung einer Verbindung (1) zwischen einer elektrischen Leitung (2) und einem mit der Leitung (2) verbundenen elektrischen Kupplungselement (3), bei welcher die Leitung (2) einen elektrisch wirksamen Schirm (4) aus einem Kohlenstofffasern enthaltenden Kunststoff aufweist, **dadurch gekennzeichnet,**
- **daß** auch das Kupplungselement (3) von einem elektrisch wirksamen Schirm (6) aus einem Kohlenstofffasern enthaltenden Kunststoff umgeben ist und
- **daß** der Schirm (6) des Kupplungselements (3) und der Schirm (4) der Leitung (2) mittels eines elektrisch leitfähigen Klebemittels, das jeweils in die Matrixstruktur des die Kohlenstofffasern enthaltenden Kunststoffs der beiden Schirme (4,6) eindringt, zu einem Gesamtschirm verbunden sind.

2. Anordnung nach Anspruch 1, **dadurch gekennzeichnet, daß** der Gesamtschirm von einer Schicht (8) aus Isoliermaterial umgeben ist.

3. Anordnung nach Anspruch 1, **dadurch gekennzeichnet, daß** ein elektrischer Leiter der Leitung (2) aus Aluminium oder einer Aluminiumlegierung besteht.

4. Anordnung nach Anspruch 1, **dadurch gekennzeichnet, daß** das Kupplungselement (3) ein Stecker oder eine Buchse ist.

5. Verwendung einer Anordnung gemäß einem der Ansprüche 1 bis 4 für elektrisch leitende Verbindungen innerhalb eines Kraftfahrzeugs.

## Claims

1. An arrangement for the electromagnetic shielding of a connection (1) between an electrical line (2) and an electrical coupling element (3) connected with the line (2), in which the line (2) has an electrically effective shield (4) made of a plastic containing carbon fibers, **characterized in**
- the coupling element (3) is also surrounded by an electrically effective shield (6) made of a plastic containing carbon fibers and
- that the shield (6) of the coupling element (3) and the shield (4) of the line (2) are connected to an overall shield by means of an electrically conductive adhesive, which in each case penetrates into the matrix structure of the plastic of both shields (4, 6) containing the carbon fibers.

2. An arrangement according to Claim 1, **characterized in that** the overall shield is surrounded by a layer (8) made of insulating material.

3. An arrangement according to Claim 1, **characterized in that** an electrical conductor of the line (2) consists of aluminum or of an aluminum alloy.

4. An arrangement according to Claim 1, **characterized in that** the coupling element (3) is a plug or a socket.

5. The use of an arrangement according to any one of Claims 1 to 4 for electrically conductive connections within a motor vehicle.

## Revendications

1. Dispositif pour le blindage électromagnétique d'une liaison (1) entre une conduite électrique (2) et un élément de couplage électrique (3) relié avec la conduite (2), dans lequel la conduite (2) comprend un blindage électrique (4) constitué d'une matière plastique contenant des fibres de carbone, **caractérisé en ce que**
- l'élément de couplage (3) est également entouré par un blindage électrique (6) constitué d'une matière plastique contenant des fibres de carbone et
- le blindage (6) de l'élément de couplage (3) et le blindage (4) de la conduite (2) sont reliés en un blindage global au moyen d'une colle électro-conductrice qui pénètre dans la structure matricielle de la matière plastique contenant des fibres de carbone des deux blindages (4, 6).

2. Dispositif selon la revendication 1, **caractérisé en ce que** le blindage global est entouré d'une couche (8) en matériau isolant.

3. Dispositif selon la revendication 1, **caractérisé en ce qu'**un conducteur de la conduite (2) est constitué d'aluminium ou d'un alliage d'aluminium.

4. Dispositif selon la revendication 1, **caractérisé en ce que** l'élément de couplage (3) est une prise mâle ou une prise femelle.

5. Utilisation d'un dispositif selon l'une des revendications 1 à 4 pour des liaisons électro-conductrices à l'intérieur d'un véhicule à moteur.
